(19) Europäisches Patentamt
European Patent Office
Office européen des brevets

(11) Veröffentlichungsnummer : **0 031 592**
**B1**

(12) # EUROPÄISCHE PATENTSCHRIFT

(45) Veröffentlichungstag der Patentschrift : **07.12.83**

(21) Anmeldenummer : **80108190.2**

(22) Anmeldetag : **24.12.80**

(51) Int. Cl.³ : **G 03 C 1/68**, G 03 C 1/71, G 03 C 1/727, G 03 F 7/00, G 03 F 7/10, C 08 L 67/06

(54) **Photopolymerisierbares Gemisch und damit hergestelltes photopolymerisierbares Kopiermaterial.**

(30) Priorität : **29.12.79 DE 2952698**

(43) Veröffentlichungstag der Anmeldung : **08.07.81 Patentblatt 81/27**

(45) Bekanntmachung des Hinweises auf die Patenterteilung : **07.12.83 Patentblatt 83/49**

(84) Benannte Vertragsstaaten : **BE CH DE FR GB IT LI NL SE**

(56) Entgegenhaltungen :
**DE-A- 2 317 522**
**FR-A- 1 253 857**
**GB-A- 1 312 655**

(73) Patentinhaber : **HOECHST AKTIENGESELLSCHAFT**
**Postfach 80 03 20**
**D-6230 Frankfurt am Main 80 (DE)**

(72) Erfinder : **Sander, Jürgen, Dr., Dipl.-Chem.**
**Berliner Ring 27**
**D-6233 Kelkheim/Ts. (DE)**
Erfinder : **Horn, Klaus, Dr., Dipl.-Chem.**
**Lessingstrasse 53**
**D-6238 Hofheim/Ts. (DE)**

EP 0 031 592 B1

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

Photopolymerisierbares Gemisch und damit hergestelltes photopolymerisierbares Kopiermaterial

Die Erfindung betrifft ein photopolymerisierbares Gemisch, das als wesentliche Bestandteile (a) eine radikalisch polymerisierbare Verbindung mit endständigen äthylenisch ungesättigten Gruppen, (b) ein polymeres Bindemittel und (c) einen Photoinitiator enthält.

Derartige photopolymerisierbare Gemische sind z. B. aus den US-Patentschriften 2 760 863, 3 060 023 und 3 149 975 bekannt. Als polymerisierbare äthylenisch ungesättigte Verbindungen werden dort niedermolekulare und hochmolekulare Verbindungen mit endständigen bzw. seitenständigen Vinyl- oder Vinylidengruppen, insbesondere Acryl- und Methacrylsäureester von niedermolekularen oder hochmolekularen Polyhydroxyverbindungen, beschrieben. In der Praxis haben sich bisher fast ausschließlich photopolymerisierbare Materialen auf der Basis solcher Ester als polymerisierbare Verbindungen durchgesetzt. Von diesen sind es insbesondere die niedermolekularen Vertreter, die in der Technik bevorzugt eingesetzt werden.

Obwohl diese Verbindungen Gemische mit hoher praktischer Lichtempfindlichkeit und Belichtungsprodukte mit hoher Vernetzungsdichte ergeben, wäre es in manchen Fällen wünschenswert, Verbindungen mit anderen Eigenschaften, z. B. mit geringerer Flüchtigkeit und Klebrigkeit oder auch höherer Beständigkeit gegen verseifende Agenzien, zur Verfügung zu haben.

Aus der DE-A 25 56 845 sind photopolymerisierbare Gemische bekannt, die als polymerisierbare Verbindungen ungesättigte Polyester von Dicarbonsäuren enthalten, die eine $\alpha$-ständige Methylengruppe aufweisen. Diese Verbindungen haben viele erwünschte mechanische und chemische Eigenschaften. Die Lichtempfindlichkeit der damit hergestellten Gemische erreicht aber nicht die der bevorzugten Acrylsäureester.

Aufgabe der Erfindung ist es, photopolymerisierbare Gemische vorzuschlagen, die in ihrer Lichtempfindlichkeit den bekannten Gemischen auf Basis von Acrylestern vergleichbar sind, aber keine flüchtigen polymerisierbaren Verbindungen enthalten, keine klebrigen Schichten ergeben und deren Lichtvernetzungsprodukte eine hohe Beständigkeit gegen aggressive, z. B. verseifende Agenzien aufweisen.

Gegenstand der Erfindung ist ein photopolymerisierbares Gemisch, das als wesentliche Bestandteile

a) eine radikalisch polymerisierbare Verbindung mit endständigen äthylenisch ungesättigten Gruppen,

b) ein polymeres Bindemittel und

c) einen Photoinitiator

enthält.

Das erfindungsgemäße Gemisch ist dadurch gekennzeichnet, daß es als radikalisch polymerisierbare Verbindung einen Polyester aus einer $\alpha,\alpha'$-Bis-methylen-dicarbonsäure und einer Dihydroxyverbindung enthält, der gegebenenfalls weniger als 10 Mol-% Einheiten von Triolen und/oder Tricarbonsäuren enthält.

Insbesondere werden als Polyester Verbindungen mit wiederkehrenden Einheiten der allgemeinen Formel I

$$\left[ -\underset{\underset{O}{\|}}{C} - \overset{\overset{CH_2}{\|}}{C} - R_1 - \overset{\overset{CH_2}{\|}}{C} - \underset{\underset{O}{\|}}{C} - O - R_2 - O - \right]_n \qquad (I)$$

verwendet, worin

$R_1$ eine zweiwertige aliphatische Gruppe mit 1 bis 15 Kohlenstoffatomen, die auch teilweise durch Heteroatome ersetzt sein können, eine zweiwertige cycloaliphatische Gruppe mit 3 bis 15 Kohlenstoffatomen, oder eine gemischt aliphatisch-aromatische Gruppe mit 7 bis 15 Kohlenstoffatomen,

$R_2$ eine zweiwertige aliphatische Gruppe mit 2 bis 50 Kohlenstoffatomen, die auch teilweise durch Heteroatome ersetzt sein können, eine zweiwertige cycloaliphatische Gruppe mit 3 bis 15 Kohlenstoffatomen oder eine gemischt aliphatisch-aromatische Gruppe mit 7 bis 15 Kohlenstoffatomen und

n eine Zahl von 2 bis 30, vorzugsweise von 2 bis 15,

ist.

In der Verbindung mit Einheiten der Formel I ist $R_1$ bevorzugt eine zweiwertige Gruppe, deren endständige Glieder acyclische aliphatische Kohlenstoffatome sind. Die endständigen Kohlenstoffatome sind bevorzugt über eine lineare aliphatische Kette verbunden. Diese Kette kann durch Heteroatome, wie O, NH und S, insbesondere O ; durch cycloaliphatische Ringe, insbesondere Cyclohexylenringe ; durch Phenylengruppen oder olefinische Doppelbindungen unterbrochen sein. $R_1$ ist bevorzugt eine Alkylengruppe mit 1 bis 5 Kohlenstoffatomen, ganz besonders bevorzugt eine Trimethylengruppe.

$R_2$ ist bevorzugt eine Gruppe der Formel

$$-C_mH_{2m}-(OC_mH_{2m}-)_k,$$

worin

m eine Zahl von 2 bis 8 und

k Null oder eine Zahl von 1 bis 15

bedeutet.

Die in den erfindungsgemäßen Gemischen verwendeten ungesättigten Polyester sind bevorzugt linear, d. h. ausschließlich aus Dicarbonsäuren und Dihydroxyverbindungen aufgebaut. Sie können aber auch weniger als 10 Mol-% Einheiten von Tricarbonsäuren und bzw. oder Triolen enthalten, solange dadurch die Löslichkeit der Verbindungen in organischen Lösungsmitteln und in den gewünschten, bevorzugt wäßrigen, Entwicklerlösungen nicht beeinträchtigt wird.

Für die Herstellung der ungesättigten linearen Polyester geeignete Dicarbonsäuren sind z. B. :

Hexa-1,5-dien-2,5-dicarbonsäure
Hepta-1,6-dien-2,6-dicarbonsäure
4-Oxa-hepta-1,6-dien-2,6-dicarbonsäure
4,4-Dimethyl-hepta-1,6-dien-2,6-dicarbonsäure
4,4-Diäthyl-hepta-1,6-dien-2,6-dicarbonsäure
Octa-1,7-dien-2,7-dicarbonsäure
Nona-1,8-dien-2,8-dicarbonsäure
Deca-1,9-dien-2,9-dicarbonsäure
Undeca-1,10-dien-2,10-dicarbonsäure
Dodeca-1,11-dien-2,11-dicarbonsäure
Trideca-1,12-dien-2,12-dicarbonsäure
Tetradeca-1,13-dien-2,13-dicarbonsäure
Hexadeca-1,15-dien-2,15-dicarbonsäure
5-Oxa-nona-1,8-dien-2,8-dicarbonsäure
5-Thia-nona-1,8-dien-2,8-dicarbonsäure
Octa-1,4,7-trien-2,7-dicarbonsäure
6-Oxa-undeca-1,10-dien-2,10-dicarbonsäure
5,8-Dioxa-dodeca-1,11-dien-2,11-dicarbonsäure
5,8,11-Trioxa-pentadeca-1,14-dien-2,14-dicarbonsäure
1,2-Bis-(2-carboxy-prop-2-en-yl)benzol
1,3-Bis-(2-carboxy-prop-2-en-yl)benzol
1,4-Bis-(2-carboxy-prop-2-en-yl)benzol
1,4-Bis-(2-carboxy-prop-2-en-yl)cyclohexan.

Die ungesättigten Polyester können nach bekannten Verfahren entweder durch Polykondensation von Dicarbonsäuren mit Dihydroxyverbindungen oder durch Umesterung von Dicarbonsäureestern der Formel

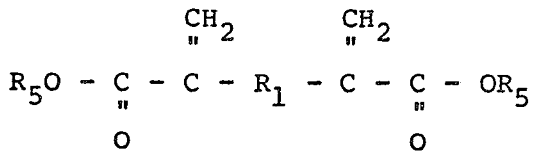

in der $R_5$ eine niedere Alkylgruppe, vorzugsweise mit 1 bis 4 C-Atomen bedeutet, mit Dihydroxyverbindungen hergestellt werden. Im allgemeinen werden bei der Umesterungsreaktion die Dimethyl- bzw. Diäthylester eingesetzt. Die Herstellung der oben genannten Dicarbonsäuren und ihrer Dimethyl- bzw. Diäthylester ist in der EP-A-0 031 593 beschrieben.

Dabei werden 2 Mol Malonsäuredialkylester mit 1 Mol Dibromverbindung Br-$R_1$-Br umgesetzt. Die Bis-Alkylierungsprodukte werden partiell verseift, wobei jeweils eine Carboxylgruppe jeder Malonestergruppierung freigesetzt wird, und die Dicarbonsäuren werden mit Formaldehyd unter Decarboxylierung zu den monomeren Dicarbonsäureestern umgesetzt.

Einige dieser Verbindungen sind in der Literatur beschrieben.

Der Vorteil der angegebenen Synthesemethode besteht darin, eine große Zahl der erfindungsgemäßen Verbindungen auf einheitlichem Wege leicht zugänglich zu machen.

Als geeignete Dihydroxyverbindungen kommen z. B. in Frage :

2,2-Bis-(4-hydroxyäthoxy-phenyl)propan, Pentan-1,5-diol, n-Hexan-1,6-diol, 2-Äthyl-hexan-1,6-diol, 2,3-Dimethyl-hexan-1,6-diol, Heptan-1,7-diol, Cyclohexan-1,4-diol, Nonan-1,7-diol, Nonan-1,9-diol, 3,6-Dimethylnonan-1,9-diol, Decan-1,10-diol, Dodecan-1,12-diol, 1,4-Bis-hydroxymethyl-cyclohexan, 2-Äthyl-1,4-bis-hydroxymethyl-cyclohexan, 2-Methyl-cyclohexan-1,4-diäthanol, 2-Methyl-cyclohexan-1,4-dipropanol, Thio-dipropylenglykol, 3-Methyl-pentan-1,5-diol, Dibutylenglykol, Hydroxypivalinsäure-neopentylglykolester, 4,8-Bis-hydroxymethyl-tricyclodecan, n-But-2-en-1,4-diol, n-But-2-in-1,4-diol, n-Hex-3-in-2,5-diol, 1,4-Bis-(2-hydroxyäthoxy)-but-2-in, p-Xylylenglykol, 2,5-Dimethyl-hex-3-in-2,5-diol, Bis-(2-hydroxyäthyl)-sulfid, 2,2,4,4-Tetramethyl-cyclobutan-1,3-diol, Di-, Tri-, Tetra-, Penta- und Hexaäthylenglykol, Di-und Tri-propylenglykol, Polyäthylenglykole mit dem mittleren Molgewicht 200, 300, 400 und 600.

Durch Variation beider Reste $R_1$ und $R_2$ lassen sich unterschiedliche ungesättigte Polyester herstellen. Durch Verwendung unterschiedlicher Polyester bzw. von deren Gemischen lassen sich die stofflichen Eigenschaften der damit hergestellten Aufzeichnungsmaterialien breit variieren.

Es hat sich gezeigt, daß Kopierschichten mit Verbindungen der Formel I, in denen der Rest $R_1$ aus einer 3 Atome enthaltenden Kette besteht, z. B. aus dem Propylen-1,3-, 2-Oxa-propylen-1,3- oder 2,2-Dimethylpropylen-1,3-rest, die höchste Lichtempfindlichkeit aufweisen, da möglicherweise zusätzlich Cyclopolymerisationsreaktionen ablaufen können. Dies trifft insbesondere für Verbindungen I mit dem Trimethylenrest als $R_1$ zu.

Durch Auswahl geeigneter linearer Polyester kann man dann den unterschiedlichen Anforderungen, die in der Praxis an Kopierschichten gestellt werden, gerecht werden.

Auf diese Weise können z. B. die Verträglichkeit der erfindungsgemäßen Verbindungen mit Bindemitteln, die Flexibilität, die mechanische Festigkeit, die Lösungsmittelbeständigkeit oder die Entwickelbarkeit der Schicht den unterschiedlichen Bedürfnissen angepaßt werden.

Den erfindungsgemäßen Verbindungen können mit Vorteil auch herkömmliche nierdermolekulare polymerisierbare Verbindungen, die zwei oder mehr polymerisierbare Gruppen, insbesondere Acryl- oder Methacrylsäureestergruppen, enthalten, zugesetzt werden, wobei selbstverständlich zu beachten ist, daß durch diese die durch die Verwendung der neuen linear polymeren Verbindungen in der photopolymerisierbaren Masse erzielten, oben erläuterten Vorteile nicht zu stark herabgesetzt werden. Durch diesen Zusatz kann z. B. eine Weichmacherwirkung erreicht werden. Im allgemeinen sollten nicht mehr als 70 Gew.-% der Gesamtmenge an Monomeren, bevorzugt nicht mehr als 60 %, aus niedermolekularen Acrylestern bestehen.

Von den niedermolekularen polymerisierbaren Verbindungen werden insbesondere Acryl- oder Methacrylester mehrwertiger aliphatischer Alkohole bevorzugt, ganz besonders Verbindungen der Formel.

$$R_3-C(CH_2-O-\overset{\overset{\displaystyle O}{\|}}{C}-\underset{\underset{\displaystyle CH_2}{\|}}{C}-R_4)_3$$

Darin bedeuten :

$R_3$ H, eine Alkylgruppe mit 1 bis 6 C-Atomen, vorzugsweise eine Methyl- oder Äthylgruppe, eine Nitro- oder Methylolgruppe und

$R_4$ H oder eine Methylgruppe.

Geeignete Verbindungen der Formel sind z. B. Triacrylate und Trimethacrylate des Trimethylolmethans, Trimethyloläthans, Trimethylolpropans, Trimethylolnitromethans und Pentaerythrits.

Die Gesamtmenge an polymerisierbaren Verbindungen in dem photopolymerisierbaren Gemisch liegt im allgemeinen zwischen etwa 10 und 90, vorzugsweise zwischen 20 und 60 Gew.-%.

Die neuen photopolymerisierbaren Gemische können je nach geplanter Anwendung und je nach den gewünschten Eigenschaften verschiedenartige Stoffe als Zusätze enthalten. Beispiele sind :

Inhibitoren zur Verhinderung der thermischen Polymerisation der Massen,
Wasserstoffdonatoren,
die sensitometrischen Eigenschaften derartiger Schichten modifizierende Stoffe,
Farbstoffe,
gefärbte und ungefärbte Pigmente,
Farbbildner,
Indikatoren,
Weichmacher usw.

Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des kurzwelligen sichtbaren Lichts entspricht. Geeignet ist insbesondere langwellige UV-Strahlung, aber auch Elektronen-, Röntgen- und Laserstrahlung.

Als Photoinitiatoren in dem erfindungsgemäßen Gemisch können eine Vielzahl von Substanzen Verwendung finden. Beispiele sind Benzoin, Benzoinäther, Mehrkernchinone, z. B. 2-äthyl-anthrachinon, Acridinderivate, z. B. 9-Phenyl-acridin, 9-p-Methoxyphenyl-acridin, 9-Acetyl-aminoacridin, Benz(a)acridin ; Phenazinderivate, z. B. 9,10-Dimethyl-benz(a)phenazin, 9-Methyl-benz(a)phenazin, 10-Methoxybenz(a)phenazin ; Chinoxalinderivate, z. B. 6,4',4''-Trimethoxy-2,3-diphenylchinoxalin, 4',4''-Dimethoxy-2,3-diphenyl-5-azachinoxalin ; Chinazolinderivate und bestimmte Trichlormethyl-s-triazine. Die Menge

an Photoinitiator liegt im allgemeinen zwischen 0,1 und 10 Gew.-%, bezogen auf die nichtflüchtigen Anteile des Gemischs.

Wenn die Bebilderung mit Elektronenstrahlung durchgeführt wird, sind neben den bekannten für sichtbares und nahes UV-Licht empfindlichen photolytischen Säurespendern auch solche geeignet, deren Absorptionsbereiche im kürzerwelligen Teil des elektromagnetischen Spektrums liegen und die damit gegenüber Tageslicht wenig empfindlich sind. Dies hat den Vorteil, daß man die Aufzeichnungsmaterialien ohne Lichtausschluß handhaben kann und daß die Materialien besser lagerfähig gemacht werden können.

Als Beispiele für derartige Starter sind Tribrommethylphenyl-sulfon, 2,2',4,4',6,6'-Hexabrom-diphenylamin, Pentabromäthan, 2,3,4,5-Tetrachlor-anilin, Pentaerythrit-tetrabromid, Chlorterphenylharze oder chlorierte Paraffine zu nennen.

Als Wasserstoffdonatoren werden in der Hauptsache aliphatische Polyäther verwendet. Gegebenenfalls kann diese Funktion auch vom Bindemittel oder von dem polymerisierbaren Monomeren übernommen werden, wenn diese labile Wasserstoffatome besitzen.

Als Bindemittel können eine Vielzahl löslicher organischer, vorzugsweise gesättigter Polymerisate Einsatz finden. Als Beispiele seien genannt : Polyamide, Polyvinylester, Polyvinylacetale, Polyvinyläther, Polyacrylsäureester, Polymethacrylsäureester, Polyester, Alkydharze, Polyacrylamid, Polyvinylalkohol, Polyäthylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z. B. Gelatine, Celluloseäther und dgl.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z. B. die folgenden Gruppen enthalten : $-COOH$, $-PO_3H_2$, $-SO_3H$, $-SO_2NH_2$, $-SO_2-NH-CO-$ und dgl. Als Beispiele hierfür seien genannt : Maleinatharze, Polymerisate aus N-(p-Tolyl-sulfonyl)-carbaminsäure-(β-methacryloyloxy-äthyl) ester und Mischpolymerisate dieser und ähnlicher Monomerer mit anderen Monomeren und Styrol-Maleinsäureanhydrid-Mischpolymerisate. Methylmethacrylat-Methacrylsäure-Mischpolymerisate und Mischpolymerisate aus Methacrylsäure, Alkylmethacrylaten und Methylmethacrylat und/oder Styrol, Acrylnitril u. a., wie sie in den DE-AS-20 64 080 und 23 63 806 beschrieben sind, werden bevorzugt.

Die Menge des Bindemittels beträgt im allgemeinen 10 bis 90, vorzugsweise 40 bis 80 Gew.-% der nichtflüchtigen Bestandteile des Gemischs.

Das photopolymerisierbare Gemisch kann für die verschiedensten Anwendungen Einsatz finden, beispielsweise zur Herstellung von Sicherheitsglas, von Lacken, die durch Licht oder Korpuskularstrahlen, z. B. Elektronenstrahlen, gehärtet werden, auf dem Dentalgebiet und insbesondere als lichtempfindliches Kopiermaterial auf dem Reproduktionsgebiet.

Die detaillierte Beschreibung der Erfindung beschränkt sich auf dieses Anwendungsgebiet, jedoch ist die Erfindung nicht hierauf beschränkt. Als Anwendungsmöglichkeiten auf diesem Gebiet seien genannt : Kopierschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Kopierschichten für die photomechanische Herstellung von Flachdruckformen und von Ätzreservagen, insbesondere als vorsensibilisierte Materialien.

Die gewerbliche Verwertung des Gemischs für die genannten Anwendungszwecke kann in der Form einer flüssigen Lösung oder Dispersion, z. B. als sogenannter Kopierlack, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckformen, vorliegen, Ebenso ist es für die Herstellung von Trockenresist geeignet.

Es ist im allgemeinen günstig, die Gemische während der Lichtpolymerisation dem Einfluß des Luftsauerstoffes weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Wachse, Polyvinylalkohol, Polyphosphate, Zucker usw.

Als Träger für mit dem erfindungsgemäßen Gemisch hergestellte Kopiermaterialien sind beispielsweise Aluminium, Stahl, Zink, Kupfer und Kunststoff-Folien, z. B. aus Polyäthylenterephthalat oder Cellulosacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die

Haftung der Schicht richtig einzustellen bzw. das Reflexionsvermögen des Trägers im aktinischen Bereich der Kopierschicht herabzusetzen (Lichthofschutz).

Die Herstellung der lichtempfindlichen Materialien unter Verwendung des erfindungsgemäßen Gemischs erfolgt in bekannter Weise.

So kann man dieses in einem Lösungsmittel aufnehmen und die Lösung bzw. Dispersion durch Gießen, Sprühen, Tauchen, Antrag mit Walzen usw. auf den vorgesehenen Träger als Film antragen und anschließend antrocknen. Dicke Schichten (z. B. von 250 µm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und angetrocknet. Die lichtempfindlichen Schichten — Dicke etwa zwischen 10 und 100 µm — werden dann gleichfalls zunächst durch Laminieren zusammen mit dem temporären Träger auf das gewünschte Substrat auflaminiert.

Die Verarbeitung der Kopiermaterialien wird in bekannter Weise vorgenommen. Zur Entwicklung werden sie mit einer geeigneten Entwicklerlösung, bevorzugt einer schwach alkalischen wäßrigen Lösung, behandelt, wobei die unbelichteten Anteile der Schicht entfernt werden und die belichteten Bereiche der Kopierschicht auf dem Träger zurückbleiben.

Im folgenden werden Beispiele für die erfindungsgemäße Kopiermasse angegeben. Dabei wird zunächst die Herstellung einer Anzahl neuer Polyester beschrieben. Die allgemeine Vorschrift A beschreibt die Umesterung von Dicarbonsäureestern mit Dihydroxyverbindungen, die allgemeine Vorschrift B die Polykondensation von Dicarbonsäuren mit Dihydroxyverbindungen. Die jeweils resultierenden Polyester wurden in erfindungsgemäßen Kopiermassen als polymerisierbare Verbindungen 1 bis 22 durchnumeriert und kehren unter dieser Bezeichnung in den Anwendungsbeispielen wieder.

In den Beispielen stehen Gewichtsteile (Gt) und Volumteile (Vt) im Verhältnis von g zu $cm^3$. Prozent- und Mengenverhältnisse sind, wenn nichts anderes angegeben ist, in Gewichtseinheiten zu verstehen.

Allgemeine Vorschrift A zur Herstellung der Verbindungen 1 bis 12

Ungesättigter Dicarbonsäureester $R_5OOC{-}\overset{\overset{CH_2}{\|}}{C}{-}R_1{-}\overset{\overset{CH_2}{\|}}{C}{-}COOR_5$ und Diol im Molverhältnis 1 : 1 werden in Gegenwart von 1 Gew.-% Zinkacetat, 1 Gew.-% Hydrochinon und 1 Gew.-% Kupfer-I-chlorid 5 Stunden bei 175 °C und 934 mbar im Kugelrohr umgesetzt. Der entstandene Alkohol wird abdestilliert. Der Rückstand wird anschließend 1 Stunde bei 100 °C und 27 mbar und 1 Stunde bei 100 °C und 0, 13 mbar getrocknet. Der Polyester verbleibt als viskoser Rückstand in praktisch quantitativer Ausbeute.

Die so hergestellten Polyester 1 bis 12 zeigen im IR-Spektrum keine OH-Bande. Die für die vinylischen Protonen charakteristischen Signale im NMR-Spektrum sind in Tabelle 1 angegeben.

Tabelle 1

Polyester mit Einheiten der allgemeinen Formel I

| Verbindung Nr. | $R_1$ | $R_2$ | NMR-Signale der vinylischen Protonen | |
|---|---|---|---|---|
| | | | δ (ppm) | ($CDCl_3$) |
| 1 | $-(CH_2)_2-$ | $-(CH_2)_2-O-(CH_2)_2-$ | 6,16 | 5,50 |
| 2 | $-(CH_2)_3-$ | $-(CH_2)_2-O-(CH_2)_2-$ | 6,22 | 5,59 |
| 3 | $-(CH_2)_4-$ | $-(CH_2)_2-O-(CH_2)_2-$ | 6,14 | 5,52 |
| 4 | $-(CH_2)_5-$ | $-(CH_2)_2-O-(CH_2)_2-$ | 6,13 | 5,50 |
| 5 | $-(CH_2)_6-$ | $-(CH_2)_2-O-(CH_2)_2-$ | 6,10 | 5,47 |
| 6 | $-(CH_2)_{10}-$ | $-(CH_2)_2-O-(CH_2)_2-$ | 6,12 | 5,50 |
| 7 | $-(CH_2)_2-O-(CH_2)_2-$ | $-(CH_2)_2-O-(CH_2)_2-$ | 6,22 | 5,62 |
| 8 | $-(CH_2CH_2O)_2(CH_2)_2-$ | $-(CH_2)_2-O-(CH_2)_2-$ | 6,23 | 5,65 |
| 9 | $-(CH_2CH_2O)_3(CH_2)_2-$ | $-(CH_2)_2-O-(CH_2)_2-$ | 6,24 | 5,66 |
| 10 | $-H_2C-$phenylen$-1,4-CH_2-$ | $-(CH_2)_2-O-(CH_2)_2-$ | 6,20 | 5,42 |
| 11 | $-H_2C-$phenylen$-1,3-CH_2-$ | $-(CH_2)_2-O-(CH_2)_2-$ | 6,22 | 5,43 |
| 12 | $-H_2C-$phenylen$-1,2-CH_2-$ | $-(CH_2)_2-O-(CH_2)_2-$ | 6,22 | 5,23 |

Allgemeine Vorschrift B zur Herstellung der Verbindungen 13 bis 22

Ungesättigte Dicarbonsäure und Diol im Molverhältnis 1 : 1,2 werden in Toluol in Gegenwart von 1 Gew.-% eines sauren Katalysators, z. B. konzentrierter Schwefelsäure, und 1 Gew.-% eines Polymerisationsinhibitors, z. B. Hydrochinon, so lange unter Rückfluß am Wasserabscheider erhitzt, bis die theoretische Menge Wasser entstanden ist. Die organische Phase wird gewaschen, getrocknet, filtriert und vom Lösungsmittel befreit. Der Polyester verbleibt als viskoser Rückstand nach jeweils einstündigem Trocknen bei 100 °C und 27 mbar und 100 °C und 0,13 mbar. Die so hergestellten Polyester 13 bis 21 zeigen im IR-Spektrum keine OH-Bande. Die für die vinylischen Protonen charakteristischen Signale im NMR-Spektrum entsprechen den bereits angegebenen Werten. Die Ausbeuten sind in Tabelle 2 angegeben.

Tabelle 2

Polyester mit Einheiten der allgemeinen Formel I

| Verbindung Nr. | $R_1$ | $R_2$ | Ausbeute (%) |
|---|---|---|---|
| 13 | $-(CH_2)_3-$ | $-CH_2-$cyclohexylen$-1,4-CH_2-$ | 70 |
| 14 | $-(CH_2)_3-$ | $-(CH_2)_2-$ | 53 |
| 15 | $-(CH_2)_3-$ | $-(CH_2CH_2O)_2-(CH_2)_2-$ | 59 |
| 16 | $-(CH_2)_3-$ | $-(CH_2)_5-$ | 72 |
| 17 | $-(CH_2)_3-$ | $-(CH_2)_3-$ | 67 |
| 18 | $-(CH_2)_3-$ | $-(CH_2)_4-$ | 53 |
| 19 | $-(CH_2)_3-$ | $-(CH_2)_6-$ | 93 |
| 20 | $-(CH_2)_3-$ | $-(CH_2CH_2O)_3-(CH_2)_2-$ | 68 |
| 21 | $-(CH_2)_3-$ | $-(CH_2)_{10}-$ | 95 |
| 22 | $-(CH_2)_3-$ | $-C(CH_3)_2-$(phenylen $1,4-O-(CH_2)_2-)_2$ | 90 |

Beispiel 1

Als Schichtträger für Druckplatten wurde elektrochemisch aufgerauhtes und anodisiertes Aluminium mit einer Oxidschicht von 3 g/m² verwendet, das mit einer wäßrigen Lösung von Polyvinylphosphonsäure vorbehandelt worden war. Der Träger wurde mit einer Lösung folgender Zusammensetzung überzogen:

11,7 Gt einer 33,4 %igen Lösung eines Methylmethacrylat/Methacrylsäure-Mischpolymerisats mit der Säurezahl 110 und dem mittleren Mol-Gewicht 35 000 in Methyläthylketon,
2,0 Gt ungesättigter Polyester (Verbindungen 1-22),
2,0 Gt Trimethyloläthantriacrylat,
0,07 Gt 9-Phenyl-acridin,
0,07 Gt 4-Dimethylamino-4'-methyl-dibenzalaceton,
0,04 Gt eines Azofarbstoffs aus 2,4-Dinitro-6-chlor-benzoldiazoniumsalz und 2-Methoxy-5-acetylamino-N-cyanäthyl-N-hydroxyäthylanilin,
38,0 Gt Äthylenglykolmonoäthyläther,
13,5 Gt Butylacetat.

Das Auftragen erfolgte durch Aufschleudern in der Weise, daß ein Trockengewicht von 2,8-3 g/m² erhalten wurde. Anschließend wurde die Platte 2 Minuten bei 100 °C im Umlufttrockenschrank getrocknet.

Die lichtempfindliche beschichtete Platte wurde mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 4-5 g/m² erhalten.

Die erhaltene Druckplatte wurde mittels einer 5 kW-Metallhalogenidlampe im Abstand von 110 cm unter einem 13 stufigen Belichtungskeil mit Dichteinkrementen von 0,15 30 Sekunden belichtet.

Anschließend wurde die Platte mit einem Entwickler folgender Zusammensetzung entwickelt:
120 Gt Natriummetasilikat · $H_2O$,
2,13 Gt Strontiumchlorid,
1,2 Gt nichtionogenes Netzmittel (Kokosfettalkohol-Polyoxyäthylenäther mit ca. 8 Oxyäthyleneinheiten),
0,12 Gt Antischaummittel,
4 000 Gt vollentsalztes Wasser.

Die Platte wurde mit 1 %iger Phosphorsäure sauer gestellt und mit fetter Druckfarbe eingefärbt. Es wurden die folgenden vollvernetzten Keilstufen erhalten :

| Verbindung Nr. | Keilstufen |
|---|---|
| 1 | 3 |
| 2 | 5 |
| 3 | 2 |
| 4 | 3 |
| 5 | 4 |
| 6 | 1 |
| 7 | 1 |
| 8 | 1 |
| 9 | 2 |
| 10 | 1/2 |
| 11 | 1/2 |
| 12 | 2 |
| 13 | 2 |
| 14 | 3 |
| 15 | 2 |
| 16 | 3 |
| 17 | 3 |
| 18 | 2 |
| 19 | 1 |
| 20 | 2 |
| 21 | 4 |
| 22 | 4 |

## Beispiel 2

Auf den in Beispiel 1 angegebenen Schichtträger wurde eine Lösung folgender Zusammensetzung so aufgeschleudert, daß ein Schichtgewicht von 3 g/m² erhalten wurde :

11,7 Gt der in Beispiel 1 angegebenen Mischpolymerisatlösung,
38,0 Gt Äthylenglykolmonoäthyläther,
13,5 Gt Butylacetat,
3,9 Gt Polyester,
0,07 Gt 9-Phenyl-acridin,
0,04 Gt des in Beispiel 1 angegebenen Azofarbstoffs,
0,07 Gt 4-Dimethylamino-4'-methyl-dibenzalaceton.

Die Platte wurde in gleicher Weise wie in Beispiel 1 weiterverarbeitet.
Es wurde die folgende Anzahl vollvernetzter Keilstufen erhalten :

| Verbindung Nr. | Belichtungszeit (Sekunden) | Keilstufe |
|---|---|---|
| 2 | 15 | 2 |
| | 30 | 5 |
| 5 | 15 | 1 |
| | 30 | 3 |
| 4 | 15 | 1 |
| | 30 | 3 |
| 21 | 15 | 2 |
| | 30 | 4 |
| 14 | 15 | 1 |
| | 30 | 2 |
| 16 | 15 | 1 |
| | 30 | 3 |
| 17 | 15 | 1 |
| | 30 | 3 |

Vergleichbare Ergebnisse wurden erhalten, wenn an Stelle von 9-Phenyl-acridin das 2,2-Dimethoxy-2-phenylacetophenon oder 2-(4-Äthoxy-naphth-1-yl)-4,6-bis-trichlormethyl-s-triazin bzw. 2-(Acenaphth-5-yl)-4,6-bis-trichlormethyl-s-triazin verwendet wurde.

Mit den Verbindungen 2 und 21 wurden Druckversuche durchgeführt, die nach 150 000 Drucken abgebrochen wurden, obwohl noch keine Ausbrüche im 60-er Raster feststellbar waren. Wenn an Stelle der doppelt ungesättigten Polyester die einfach ungesättigten Polyester auf der Basis Itaconsäure, α-Methylenglutarsäure und α-Methylen-δ-methyladipinsäure und jeweils Diäthylenglykol verwendet wurden, so war die Vernetzungsdichte nicht ausreichend für eine Keilstufe.

## Beispiel 3

Auf den in Beispiel 1 angegebenen Schichtträger wurde eine Lösung folgender Zusammensetzung so aufgeschleudert, daß ein Schichtgewicht von 3,5 g/m² erhalten wurde :

10,0 Gt einer 21,7 %igen Lösung eines Terpolymerisates aus Styrol, n-Hexylmethacrylat und Methacrylsäure (10 : 60 : 30) mit der Säurezahl 190 in Butanon,
2,0 Gt der Verbindung 2,
0,05 Gt 9-Phenyl-acridin, und
0,03 Gt Methylviolett (C. I. 42 535) in
18,0 Gt Butanon und
7,5 Gt Butylacetat.

Die beschichtete Platte wurde anschließend 2 Minuten bei 100 °C im Umlufttrockenschrank getrocknet und mit einer Deckschicht wie in Beispiel 1 versehen. Die Platte wurde unter einem 13-stufigen Belichtungskeil wie in Beispiel 1 beschrieben 4, 8, 15 und 30 Sekunden belichtet und mit einem Entwickler folgender Zusammensetzung entwickelt :

5,3 Gt Natrium-metasilikat · 9 $H_2O$
3,4 Gt tert. Natriumphosphat · 12 $H_2O$
0,3 Gt sec. Natriumphosphat · 12 $H_2O$
91,0 Gt vollentsalztes Wasser

Die Platte wurde mit 1 %iger Phosphorsäure sauer gestellt und mit fetter Druckfarbe eingefärbt. Die Auszählung der vollvernetzten Glanzstufen ergab folgendes Bild :

| Belichtungszeit | Sekunden | | | |
|---|---|---|---|---|
| MH-Lampe 5 kW | 4 | 8 | 15 | 30 |
| entsprechende vollvernetzte Glanzstufen | 1 | 3 | 5 | 7 |

## Beispiel 4

Eine Lösung, wie in Beispiel 3 beschrieben, wurde auf einen gereinigten Träger, der aus einem Isolierstoffmaterial mit 35 µm Kupferauflage bestand, so aufgeschleudert, daß eine Schichtdicke von ca. 5 µm erhalten wurde. Die Schicht wurde 5 Minuten bei 100 °C im Umlufttrockenschrank nachgetrocknet. Anschließend wurde eine Deckschicht wie in Beispiel 1 aufgebracht. Der Beschichtungs- und Trocknungsvorgang kann auch beidseitig durchgeführt werden.

Anschließend wurde mittels einer 5 kW MH-Lampe mit 140 cm Abstand unter einem Stufenkeil wie in Beispiel 1 beschrieben 2, 4, 8, 16, 32 und 64 Sekunden belichtet und die Platte mit 0,8 %iger Sodalösung in einem Sprühprozessor zwischen 30 und 60 Sekunden entwickelt.

Es wurden die folgenden vollvernetzten Keilstufen erhalten :

| Belichtungszeit (Sekunden) | Keilstufen |
|---|---|
| 2 | 0 |
| 4 | 2 |
| 8 | 5 |
| 16 | 7 |
| 32 | 9 |
| 64 | 10 |

Wenn die vernetzbare Schicht unter einer Schaltvorlage belichtet und entwickelt wurde, waren die vernetzten Bereiche gegen die in der Leiterplattentechnik übliche Eisen-III-chlorid-Lösung resistent. Die Ätzfestigkeit war gut.

## Ansprüche

1. Photopolymerisierbares Gemisch, das als wesentliche Bestandteile

a) eine radikalisch polymerisierbare Verbindung mit endständigen äthylenisch ungesättigten Gruppen,

b) ein polymeres Bindemittel und

c) einen Photoinitiator

enthält, dadurch gekennzeichnet, daß die radikalisch polymerisierbare Verbindung ein Polyester aus einer α,α'-Bis-methylen-dicarbonsäure und einer Dihydroxyverbindung ist, der gegebenenfalls weniger als 10 Mol-% Einheiten von Triolen und/oder Tricarbonsäuren enthält, solange dadurch die Löslichkeit der Verbindungen in organischen Lösungsmitteln und in den Entwicklerlösungen nicht beeinträchtigt wird.

2. Photopolymerisierbares Gemisch nach Anspruch 1, dadurch gekennzeichnet, daß der Polyester eine Verbindung mit wiederkehrenden Einheiten der allgemeinen Formel I

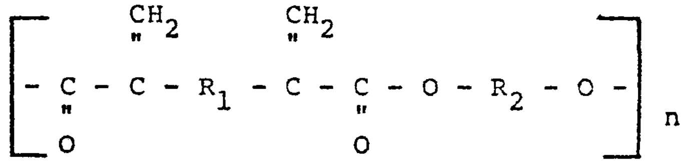

(I)

ist, worin

$R_1$ eine zweiwertige aliphatische Gruppe mit 1 bis 15 Kohlenstoffatomen, die auch teilweise durch Heteroatome ersetzt sein können, eine zweiwertige cycloaliphatische Gruppe mit 3 bis 15 Kohlenstoffatomen, oder eine gemischt aliphatisch-aromatische Gruppe mit 7 bis 15 Kohlenstoffatomen,

$R_2$ eine zweiwertige aliphatische Gruppe mit 2 bis 50 Kohlenstoffatomen, die auch teilweise durch Heteroatome ersetzt sein können, eine zweiwertige cycloaliphatische Gruppe mit 3 bis 15 Kohlenstoffatomen oder eine gemischt aliphatisch-aromatische Gruppe mit 7 bis 15 Kohlenstoffatomen und

n eine Zahl von 2 bis 30

ist.

3. Photopolymerisierbares Gemisch nach Anspruch 2, dadurch gekennzeichnet, daß es eine Verbindung mit wiederkehrenden Einheiten der allgemeinen Formel I enthält, worin $R_1$ eine Alkylengruppe mit 1 bis 5 Kohlenstoffatomen ist.

4. Photopolymerisierbares Gemisch nach Anspruch 2, dadurch gekennzeichnet, daß es eine Verbindung mit wiederkehrenden Einheiten der allgemeinen Formel I enthält, worin $R_2$ eine Gruppe der Formel

$$-C_mH_{2m}-(OC_mH_{2m}-)_k,$$

ist, in der

m eine Zahl von 2 bis 8 und

k Null oder eine Zahl von 1 bis 15

bedeutet.

5. Photopolymerisierbares Kopiermaterial aus einem Schichtträger und einer photopolymerisierbaren Schicht, die als wesentliche Bestandteile

a) eine radikalisch polymerisierbare Verbindung mit endständigen äthylenisch ungesättigten Gruppen,

b) eine polymeres Bindemittel und

c) einen Photoinitiator

enthält, dadurch gekennzeichnet, daß die radikalisch polymerisierbare Verbindung ein Polyester aus einer α,α'-Bis-methylen-dicarbonsäure und einer Dihydroxyverbindung ist, die gegebenenfalls weniger als 10 Mol-% Einheiten von Triolen und/oder Tricarbonsäuren enthält, solange dadurch die Löslichkeit der Verbindungen in organischen Lösungsmitteln und in den Entwicklerlösungen nicht beeinträchtigt wird.

## Claims

1. A photopolymerizable composition containing, as the essential constituents,

a) a compound which is polymerizable by a free-radical mechanism and has terminal ethylenically unsaturated groups,

b) a polymeric binder and

c) a photoinitiator,

which comprises, as the compound which is polymerizable by a free-radical mechanism, a polyester of an α,α'-bis-methylene-dicarboxylic acid and a dihydroxy compound which polyester contains, if desired, less than 10 mol-% of units derived from triols and/or tricarboxylic acids, provided that the solubility of the compounds in organic solvents and in the developer solutions is not impaired.

2. A photopolymerizable composition as claimed in claim 1, which comprises, as the polyester, a compound having recurring units of the general formula I

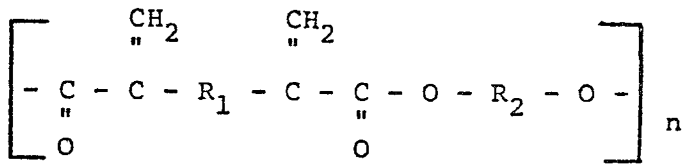

(I)

in which

$R_1$ is a divalent aliphatic group having 1 to 15 carbon atoms which can also be partially replaced by hetero-atoms, a divalent cycloaliphatic group having 3 to 15 carbon atoms, or a mixed aliphatic-aromatic group having 7 to carbon atoms,

$R_2$ is a divalent aliphatic group having 2 to 50 carbon atoms which can also be partially replaced by hetero-atoms, a divalent cycloaliphatic group having 3 to 15 carbon atoms or a mixed aliphatic-aromatic group having 7 to 15 carbon atoms and

n is a number from 2 to 30.

3. A photopolymerizable composition as claimed in claim 2, which comprises a compound having recurrent units of the general formula I, in which $R_1$ is an alkylene group having 1 to 5 carbon atoms.

4. A photopolymerizable composition as claimed in claim 2, which comprises a compound having recurring units of the general formula I, in which $R_2$ is a group of the formula

$$-C_mH_{2m}-(OC_mH_{2m}-)_k$$

in which

m is a number from 2 to 8 and

k is zero or a number from 1 to 15.

5. A photopolymerizable reproduction material, having a support and a photopolymerizable layer which contains, as the essential constituents,

a) a compound which is polymerizable by a free radical mechanism and has terminal ethylenically unsaturated groups,

b) a polymeric binder and

c) a photoinitiator,

wherein the compound which is polymerizable by a free-radical mechanism is a polyester of an α,α'-bis-methylene-dicarboxylic acid and a dihydroxy compound, which polyester contains, if desired, less than 10 mol-% of units derived from triols and/or tricarboxylic acids, provided that the solubility of the compounds in organic solvents and in the developer solutions is not impaired.

**Revendications**

1. Mélange photopolymérisable qui contient comme constituants essentiels

a) un composé polymérisable par voie radicalaire avec des groupes terminaux à insaturation éthylénique,

b) un liant polymère et,

c) un photoinitiateur,

caractérisé en ce que le composé polymérisable par voie radicalaire est un polyester d'un acide α,α'-bis-méthylènedicarboxylique et d'un composé dihydroxylé qui contient éventuellement moins de 10 moles % de motifs de triols et/ou d'acides tricarboxyliques, pour autant que la solubilité des composés dans les solvants organiques et dans les solutions de révélateur ne s'en trouve pas compromise.

2. Mélange photopolymérisable suivant la revendication 1, caractérisé en ce que le polyester est un composé ayant des motifs récurrents répondant à la formule générale I

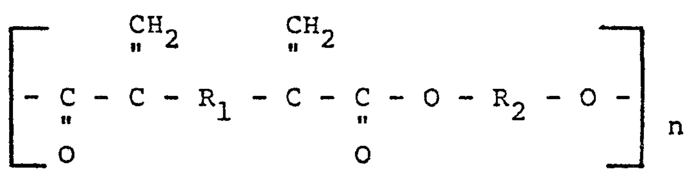

(I)

dans laquelle

$R_1$ est un groupe aliphatique divalent avec de 1 à 15 atomes de carbone, qui peuvent aussi être remplacés partiellement par des hétéroatomes, un groupe cycloaliphatique divalent avec de 3 à 15 atomes de carbone, ou un groupe mixte aliphatique-aromatique avec de 7 à 15 atomes de carbone,

$R_2$ est un groupe aliphatique divalent avec de 2 à 50 atomes de carbone, qui peuvent aussi être remplacés partiellement par des hétéroatomes, un groupe cycloaliphatique divalent avec de 3 à 15 atomes de carbone ou un groupe mixte aliphatique-aromatique avec de 7 à 15 atomes de carbone, et

n est un nombre de 2 à 30.

2. Mélange photopolymérisable suivant la revendication 2, caractérisé en ce qu'il contient un composé ayant des motifs récurrents répondant à la formule générale I, dans laquelle $R_1$ est un groupe alcoylène avec de 1 à 5 atomes de carbone.

4. Mélange photopolymérisable suivant la revendication 2, caractérisé en ce qu'il contient un composé ayant des motifs récurrents répondant à la formule générale I, dans laquelle $R_2$ est un groupe de formule

$$-C_mH_{2m}-(OC_mH_{2m}-)_k,$$

dans laquelle

m désigne un nombre de 2 à 8 et

k désigne zéro ou un nombre de 1 à 15.

5. Matériau de reproduction photopolymérisable constitué d'un support de couche et d'une couche photopolymérisable qui contient comme constituants essentiels

a) un composé polymérisable par voie radicalaire avec des groupes terminaux à insaturation éthylénique,

b) un liant polymère et

c) un photoinitiateur,

caractérisé en ce que le composé polymérisable par voie radicalaire est un polyester d'un acide $\alpha,\alpha'$-bis-méthylène-dicarboxylique et d'un composé dihydroxylé qui contient éventuellement moins de 10 moles % de motifs de triols et/ou d'acides tricarboxyliques, pour autant que la solubilité des composés dans les solvants organiques et dans les solutions de révélateur ne s'en trouve pas compromise.